Europäisches Patentamt

European Patent Office

Office européen des brevets

(19)

(11) Publication number:

**0 248 501**

**A1**

(12) **EUROPEAN PATENT APPLICATION**

(21) Application number: 87201063.2

(22) Date of filing: 05.06.87

(51) Int. Cl.⁴: **G01R 29/08** , **H05K 9/00** ,
**G01R 1/18**

(30) Priority: 06.06.86 NL 8601471

(43) Date of publication of application:
09.12.87 Bulletin 87/50

(84) Designated Contracting States:
AT BE CH DE ES FR GB IT LI LU NL SE

(71) Applicant: **Staat der Nederlanden**
**(Staatsbedrijf der Posterijen, Telegrafie en**
**Telefonie)**
P.O. Box 430
NL-2260 AK Leidschendam(NL)

(72) Inventor: **Ouderling, Johannes Marinus G.A.**
Gorterlaan 79
NL-9721 ZC Groningen(NL)

(54) Detection system for detecting imperfections in a shielding against EM radiation.

(57) Detection system for detecting imperfections in
EMP shieldings, a rotating magnetic (or electric) field
being generated outside (or inside) the shielding (2)
by means of for example pairs of Helmholtz coils
(13, 15 respectively 14, 16), which are at an angle
(of for example 90 degrees) with regard to each
other and which are driven by a modulated signal,
the modulation phase of the respective pairs of coils
differing with respect to each other with a value
which is equal to the difference between the respec-
tive angles of those pairs of coils. The field penetrat-
ing through the shielding (2) is detected in various
directions by detecting means (10). In those direc-
tions in which the field intensity is relatively high, the
shielding can be closer examined by local measure-
ments.

In co-operation with an alarm element the detec-
tion system can ber used as a protection system
against damage of a room shielding (22), caused by
for example burglary. When it is detected that the
field penetrating through the shielding increases
(due to damage of the shielding), an alarm will be
given.

FIG.1

## Detection system for detecting imperfections in a shielding against EM radiation.

### A. Background of the invention

#### 1. Field of the invention

The invention relates to a detection system for detecting imperfections in a shielding against electromagnetic radiation. The invention particularly relates to such a detection system in which the shielding encloses a room which has to be protected against electromagnetic radiation.

#### 2. State of the art

Rooms specially meant to be used in case of calamities are as a rule provided with shieldings against electromagnetic pulses (EMP) which may occur in the case of nuclear explosions. Such shieldings have to provide such a protection in all directions that equipment installed within the rooms will continue functioning when an EMP occurs. Such shieldings are mounted during the building process of suchlike rooms and usually form a more or less integrated part of the structure of the building.

The subject of the present invention is to test the EMP shielding of a room. It is true that in principle a protected room could be exposed to an artificially generated EM pulse, and that within the room the influence of such a pulse could be measured. The artificial generation of EM pulses, however, requires a large space around the room to be tested. For testing relatively large rooms or even complete buildings this method is impracticable, notably when they are situated underground.

### B. Summary of the invention

The invention is based on the insight that for testing EMP shieldings, such shieldings need not necessarily be exposed to EM pulses to measure the shielding working, but that the testing of the quality of such shieldings can also take place surprisingly well when utilizing a magnetic or an electric field. Put into other words: imperfections in a shielding against EMP which are detected by means of a magnetic or an electric field, would also have manifested themselves as imperfections if the shielding would have been exposed to EM pulses. The invention is formed by a detection system for detecting imperfections in a shielding against electromagnetic radiation, characterized by generating means for generating a magnetic or electric field, as well as detecting means for detecting a magnetic or electric field, the generating means generating a magnetic or electric field on the one side of the shielding, and the detecting means detecting the magnetic or electric field penetrating through the shielding on the other side of the shielding. If the shielding encloses a room, the generating means can be disposed outside and the detecting means inside the room, or just the reverse - the detecting means outside and the generating means inside the room. The magnetic or electric field to which the shielding is exposed, will preferably be a stationary or quasi-stationary field.

In order to make it possible to detect imperfections in various directions, the direction of the generated field will preferably rotate. This has proved to be of vital importance for the reliable testing of EMP shieldings. In this way imperfections will come to light, which would not have been observed in the case of an immovable field. The speed of rotation is preferably low to avoid the introduction of unwanted effects (measuring errors) in consequence of quick changes of the field. To make the field rotate the generating means preferably comprise two or more excitation devices having different directions of excitation. All the excitation devices are connected to a drive element, which drives each of the excitation devices with a drive signal, which is modulated with a low frequency, for example sinusoidal modulation signal. The phase of the modulation signal is unequal for each of the excitation devices; the differences between the phases correspond with the differences between the directions of the excitation devices. In this way the rotation of the field will be achieved without it being necessary to move the generating means themselves.

In a preferred embodiment the generating means comprise two excitation devices, the directions of excitation of which are at an angle of 90 degrees with regard to each other, and the difference between the phases with which the modulation signal modulates the respective drive signals is also 90 degrees.

In order to obtain a most homogeneous magnetic or electric field at the point where the shielding has to be tested, each of the excitation devices preferably consists of two excitation elements located on either side of the shielding. A magnetic field which can be generated in a way known per se by means of Helmholtz coils acting as excitation elements will be made use of.

The present invention lends itself not only to testing EMP shieldings, for example immediately after the building or a building phase of a protected room has finished, but also very well to continuously watching the condition of a shielding. In this way the detection system according to the invention can form part of a protection system for protecting a room which is enclosed by a shielding. As soon as an imperfection (disturbance) of the shielding - caused by for example burglary - is detected, the detection system can activate an alarm system.

## C. References

None

## D. Short description of the figures

Figure 1 shows a detection system according to a preferred embodiment of the invention.

Figure 2 shows an embodiment of a protection system of which a detection system according to the invention forms part of.

Figure 3 shows a block diagram of one of the components shown in figure 2.

## E. Description of the figures and of the embodiments

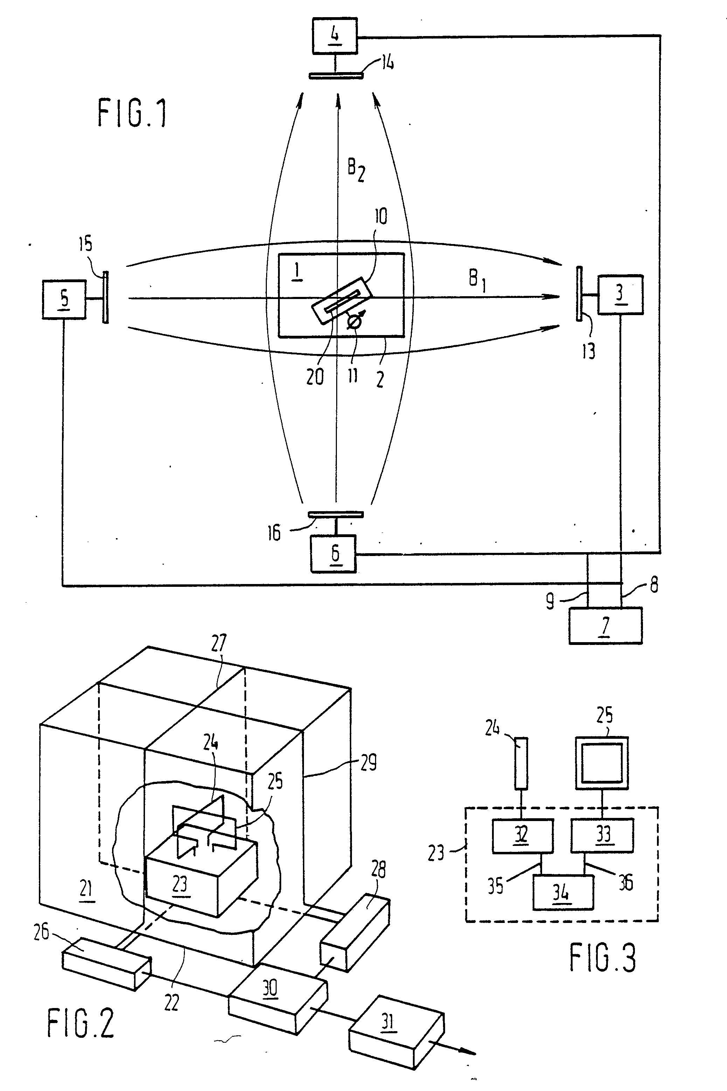

Figure 1 shows a room 1, which is protected against the influences of EM pulses by means of a shielding 2. This shielding is tested for imperfections by means of four amplifiers 3, 4, 5 and 6, which causes a high frequency current to flow through Helmholtz coils 13, 14, 15 and 16 respectively. The amplifiers 3...6 are connected to a drive element 7, namely the amplifiers 3 and 5 to an output terminal 8 and the amplifiers 4 and 6 to an output terminal 9. The drive element 7 comprises an HF oscillator for generating an HF drive signal, and an LF oscillator for generating a sinusoidal LF modulation signal, with which the amplitude of the drive signal is modulated. The drive element 7 further comprises a phase shifting element by means of which the phase of the modulation signal at the output terminal 8 is shifted 90 degrees with respect to that at the output terminal 9.

The fields B1 and B2, which are excited by the pairs of coils 13-15 and 14-16, respectively, are at right angles to each other; moreover, the modulation phases are shifted 90 degrees with respect to each other:

$B1 = Bmax \sin(2\pi f_a t) \sin(2\pi f_m t)$ and
$B2 = Bmax \sin(2\pi f_a t) \cos(2\pi f_m t)$,
in which $f_a$ is the frequency of the (sinusoidal)

drive signal and $f_m$ the frequency of the (also sinusoidal) modulation signal. The resulting magnetic field B1B2 will, consequently, rotate at a speed of rotation which is equal to the frequency $f_m$ of the modulation signal.

A mobile field-intensity meter 10 is installed within the protected room 1 and consists of an amplifier 10, at the input terminal of which a Helmholtz coil 20 is connected and at the output terminal of which a voltmeter or ammeter 11 is connected. By means of this field-intensity meter 10 the field intensity prevailing within the protected room 1 can be measured in various directions.

The testing of the shielding 2 will take place as follows: After the amplifiers 3...6 and their Helmholtz coils 13...16, respectively have been disposed outside the room 1 and connected to the drive element 7 and all these components 3...7 have been switched on, due to which the fields B1 and B2, respectively will arise, resulting in a slowly rotating field B1B2, the field-intensity maxima will be measured in various directions and recorded within the room 1 by means of the field-intensity meter 10 located in the middle of said room. From the image of the measured field-intensity maxima in the various directions it can be concluded in what directions imperfections in the shielding occur. Subsequently a close examination is carried out in these directions, for example by means of a field-intensity meter with a relatively small detection coil, which is more appropriate for local examination. Particularly welding joints in the shielding, doors, cable inlets, ventilating ducts and the like in the relevant directions will be further examined. When measuring the field-intensity maxima near cable inlets, a pair of current tongs, which is connected to the field-intensity meter, instead of to an ordinary detection coil, can also be used with success.

It is remarked that measuring the field-intensity maxima does not provide a quantitive value for the attenuation value of the shielding 2 against EM pulses, since the character of these pulses considerably differs from that of the quasi-stationary magnetic field B1B2 generated for the present measuring. The present detection system is meant to trace imperfections in the shielding 2; it provides the possibility to carry out a reliable and qualitative test of the shielding 2 by means of simple means.

To obtain additional information concerning the extent and nature of the imperfections in the shielding 2,the above-described measuring is successively carried out at various frequencies of the drive signal $f_a$, for example at 15, 30, 50 and 100 kHz.

The modulation frequency $f_m$ is chosen in such a way that measuring errors due to the changes of the amplitude in the magnetic field B1B2 (difference between field-intensity maximum and field-intensity minimum per unit of time) will be insignificantly small; for example 5 Hz is chosen for $f_m$.

Figure 2 shows a detection system according to another embodiment of the invention, in which the detection system forms part of a protection system of a room 21, which is protected by a shielding 22. A generating element 23, which, as shown in figure 3, comprises two amplifiers 32 and 33, which are connected to a drive element 34, is fixedly installed within the room. This drive element 34 corresponds with the above-mentioned drive element 7 and has two output terminals, 35 and 36, which each deliver a drive signal, the one modulated with $\sin (2\pi f_m t)$, the other one modulated with $\cos (2\pi f_m t)$ ($f_m$ = modulation frequency). The output terminals of the amplifiers 32 and 33 each supply a Helmholtz coil 24 respectively 25, which are at right angles to each other. This difference of direction of 90 degrees, combined with the phase difference in modulation of 90 degrees, causes a rotating resulting magnetic field, the speed of rotation corresponding with the modulation frequency $f_m$.

Fixed detecting means consisting of two Helmholtz coils 27 and 29, which are at right angles to each other and both enwrapping the shielding (without having a galvanic contact with the shielding 22) and which are connected to the amplifiers 26 and 28, respectively are located outside said shielding 22. The output terminals of the amplifiers 26 and 28 are connected to a control element 30, the output terminal of which is connected to an alarm element 31.

The rotating resulting magnetic field B1B2 generated within the shielding 22 by the coils 24 and 25 is considerably weakened by the shielding 22, due to which the current induced in the coils 27 and 29 will be weak. However, as soon as a disturbance in the shielding 22 occurs (for example damage caused by burglary), due to which the attenuation of the magnetic field generated within the shielding 22 will decrease, the induced current in one of the coils 27 or 29 (or in both; dependent on the location of the disturbance) will increase, which will be detected by the control element 30, and, when a threshold value is exceeded, will be passed on to the alarm element 31, which will transmit an alarm signal.

## Claims

1. Detection system for detecting imperfections in a shielding against electromagnetic radiation, characterized by generating means for generating a magnetic or electric field, as well as detecting means for detecting a magnetic or electric field, the generating means generating a magnetic or electric field on the one side of the shielding, and the detecting means detecting the magnetic or electric field penetrating through the shielding on the other side of the shielding.

2. Detection system in accordance with claim 1, the shielding enclosing a room to be protected against electromagnetic radiation, characterized in that the generating means are disposed outside said room and in that the detecting means are disposed inside this room.

3. Detection system in accordance with claim 1, the shielding enclosing a room to be protected against electromagnetic radiation, characterized in that the detecting means are disposed outside said room and in that the generating means are disposed inside this room.

4. Detection system in accordance with claim 1, characterized in that the generating means generate a stationary or a quasi-stationary magnetic field at the place of the shielding, and in that the detecting means are suited to detect a stationary respectively quasi-stationary magnetic field.

5. Detection system in accordance with claim 1, characterized in that the generating means generate a stationary or a quasi-stationary electric field at the place of the shielding, and in that the detecting means are suited to detect a stationary respectively quasi-stationary electric field.

6. Detection system in accordance with claim 2 or 3, characterized in that the generating means generate a magnetic or electric field which is rotating with respect to the shielding.

7. Detection system in accordance with claim 6, characterized in that the generating means comprise two or more excitation devices for exciting a magnetic or an electric field at the place of the shielding, which excitation devices are connected to a drive element for driving the excitation devices, the excitation devices having different directions of excitation, and the drive element driving each of the excitation devices with a drive signal, which is modulated with a low frequency modulation signal, the phase of the modulation signal being different for each of the excitation devices, and the differences between the phases corresponding with the differences between the directions of excitation.

8. Detection system in accordance with claim 7, characterized in that the modulation signal is substantially sinusoidal.

9. Detection system in accordance with claim 7 or 8, characterized in that the generating means comprise two excitation devices, the respective directions of excitation of which are substantially at right angles to each other, and the respective phase angles of the modulation signal of which differ 90 degrees with respect to each other.

10. Detection system in accordance with claim 7, 8 or 9, characterized in that each of the excitation devices comprises two excitation elements, which are located on either side of the shielding.

11. Detection system in accordance with claim 4, characterized in that the generating means comprise one or more excitation elements, consisting of Helmholtz coils.

12. Protection system for protecting a room which is enclosed by a shielding against electromagnetic, magnetic or electric fields, characterized by a detecting system in accordance with one of the preceding claims, as well as by an alarm system connected to the detection system and delivering an alarm signal as soon as the detection system detects an imperfection in the shielding.

FIG.1

B₂

B₁

15

10

1

20  11  2

16

5

13

3

6

9  8

7

27

24

25

29

23

21

26

22

30

31

FIG.2

24

25

32

33

35  34  36

23

FIG.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | ELECTRO 79 CONFERENCE RECORD, New York, 24th-26th April 1979, no. 6/2, pages 1-7; R.D. GOLDBLUM: "EMI testing of metalized plastics" <br> * Page 3, left-hand column, lines 43-48; page 3, right-hand column, lines 14-25; page 4, left-hand column, lines 10-30; figures 4,5 * | 1,3-5 | G 01 R 29/08 <br> H 05 K 9/00 <br> G 01 R 1/18 |
| Y | Idem | 12 | |
| Y | GB-A-1 057 425 (MICROTHERM LTD) <br> * Page 1, lines 8-12; claim 1 * | 12 | |
| X | US-A-2 446 195 (S.L. SHIVE) <br><br> * Column 2, line 48 - column 3, line 10; figure 1 * | 1,2,4, 5,11 | TECHNICAL FIELDS SEARCHED (Int. Cl.4) |
| X | US-A-4 565 967 (EISENBRANDT et al.) <br> * Column 5, line 45 - column 6, line 9; figures 1,3 * | 1,4,5 | G 01 R <br> H 05 K <br> G 12 B |

-/-

The present search report has been drawn up for all claims

| Place of search | Date of completion of the search | Examiner |
|---|---|---|
| THE HAGUE | 11-09-1987 | PENZKOFER,B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

## DOCUMENTS CONSIDERED TO BE RELEVANT

Page   2

| Category | Citation of document with indication, where appropriate, of relevant passages | Relevant to claim | CLASSIFICATION OF THE APPLICATION (Int. Cl.4) |
|---|---|---|---|
| A | PROCEEDINGS OF THE IEEE, vol. 74, no. 1, January 1986, pages 112-115, IEEE, New York, US; P.F. WILSON et al.: "Measurement of the electromagnetic shielding capabilities of materials" <br> * Page 114, right-hand column, lines 5-36; figure 5 * | 1 | |

-----

TECHNICAL FIELDS
SEARCHED (Int. Cl.4)

The present search report has been drawn up for all claims

| Place of search | Date of completion of the search | Examiner |
|---|---|---|
| THE HAGUE | 11-09-1987 | PENZKOFER,B. |